(19) **Europäisches Patentamt / European Patent Office / Office européen des brevets**

(11) **EP 2 775 626 A1**

(12) # EUROPEAN PATENT APPLICATION

(43) Date of publication:
**10.09.2014 Bulletin 2014/37**

(51) Int Cl.:
*H03L 7/099* (2006.01)   *H03L 1/02* (2006.01)
*H03L 7/183* (2006.01)

(21) Application number: **13290045.7**

(22) Date of filing: **07.03.2013**

---

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **NXP Semiconductors B.V.**
**5656 AG Eindhoven (NL)**

(72) Inventor: **Susplugas, Olivier**
**Redhill Surrey, RH1 1NY (GB)**

(74) Representative: **Miles, John Richard et al**
**NXP B.V.**
**Intellectual Property & Licensing**
**Red Central**
**60 High Street**
**Redhill, Surrey RH1 1SH (GB)**

---

(54) **Frequency synthesis system and method**

(57)   The invention provides a system for generating an output signal of a desired frequency in which a bank of at least two controllable oscillators are used, each having a temperature-tolerant tuning range which can be achieved at all temperatures within a desired temperature range of operation. These ranges of the oscillators overlap in frequency such that they define in combination a combined temperature-tolerant tuning range which has a larger frequency tuning range than each individual oscillator. The most suitable controllable oscillator to use to generate the output signal is selected. This avoids the need for the individual oscillators to have a tuning range which is tolerant to temperature (and process) variations.

**FIG. 11**

**Description**

This invention relates to frequency synthesis systems and methods, in particular making use of controllable oscillators such as voltage controlled oscillators (VCOs) or digitally controlled oscillators (DCOs).

Voltage controlled oscillators are used to generate oscillating signals of a desired frequency for use in signal processing. For example voltage controlled oscillators are used to provide a reference signal for downmixing RF signals in an RF receiver circuit, or for upmixing in an RF transmitter circuit.

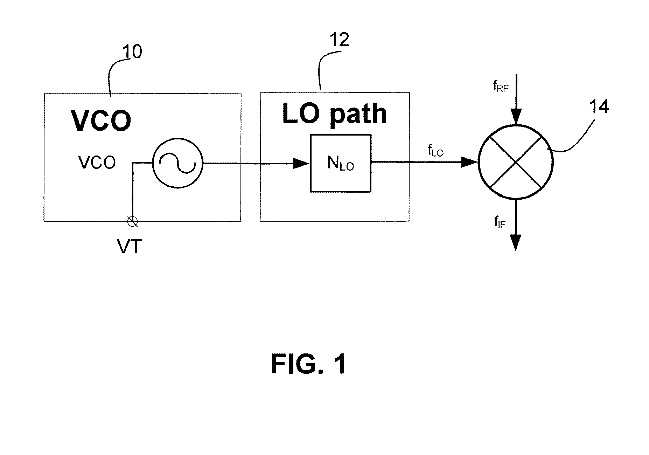

Figure 1 shows how a voltage controlled oscillator ("VCO") is used to generate a local oscillator signal $f_{LO}$ which is then used by a mixer for downmixing a radio frequency ("RF") signal $f_{RF}$ to an intermediate frequency ("IF") signal $f_{IF}$.

The VCO 10 includes a phase locked loop ("PLL"), and has a tuning voltage input VT. A local oscillator path 12 includes a divider for dividing the VCO output signal frequency by a ratio $N_{LO}$ down to the local oscillator frequency. The local oscillator signal is used to down-convert the RF signal to the IF using a mixer 14.

The chosen value of $N_{LO}$ belongs to a family of $N_{LO}$ values ($N_{LOi}$).

$$N_{LO} \in \left(N_{LO_i}\right)_{i \in [1..n]}$$

The VCO output frequency fvco, which must be within the VCO frequency range, is given by:

$$f_{VCO} = f_{LO} * N_{LO}$$

For a given value of $N_{LO}$, a shift in the desired value of $f_{LO}$ by $\Delta f$ induces a VCO frequency $\Delta$fvco shift of $N_{LO}*\Delta f$.

For example, if $\Delta f$=+/-2MHz and $N_{LO}$=128, then $\Delta$fvco=+/-256MHz, meaning that the VCO frequency range has to cover more than 500MHz. This change in the IF frequency may for example be desirable in order to move away from a source of interference.

In order to obtain frequency continuity for the LO signal over a multi octave frequency range (for example the Terrestrial Television spectrum goes from 50MHz up to 870MHz), the VCO tuning range should be equal at least to max($div_{i+1}/div_i$) of a bank of dividers used to divide the VCO signal down to the IF frequency.

It is noted that the invention can be applied to this type of VCO but also to a DPLL (Digital PLL). A DPLL contains a digitally controlled oscillator (DCO) in which the frequency of the DCO is controlled by a digital word rather than an analogue voltage.

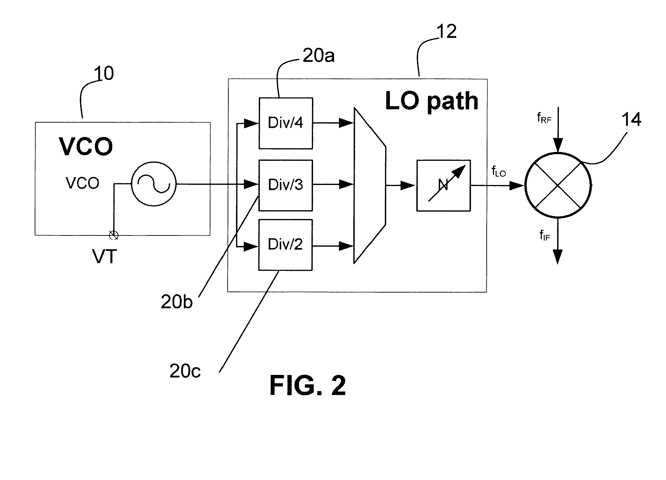

Figure 2 shows an example circuit in which the local oscillator path 12 includes three dividers 20a,20b,20c which feed a multiplexer. In the example shown, $div_3$=4, $div_2$=3 and $div_1$=2. The necessary VCO tuning ratio ("TR") should in this case be greater than 3/2: i.e. TR>50%.

Within the VCO, the synthesisable VCO frequency is controlled by a command in the form of the voltage signal VT. A given VCO can synthesise frequencies from a given minimum value up to a given maximum value. The Tuning Range ("TR") can be defined as the ratio between the maximum and the minimum frequency.

The available frequencies for a given VCO can fluctuate depending on the process and junction temperature variations within the VCO, which affect the circuit component functions. By way of example, the process variation can impact the VCO frequency for a given setting VT by around +/-4% and a temperature variation from 0°C up to 125°C can influence the frequency by 6%. These values of course depend on the process used.

For a given LO chain architecture, the desired local oscillator frequency to be.synthesised can be translated to a desired LO chain architecture and a VCO frequency band. To ensure the desired VCO band, the designer has to consider frequency margin above and below the band to enable the VCO to tolerate process and temperature variations.

This means the minimum frequency needs to be decreased and the maximum frequency needs to be increased by (4+3)%, respectively. Consequently, the VCO tuning range increases.

For example, for a fvco=9GHz, the VCO frequency range has to be increased beyond the normal tuning range by 2*630MHz=1260MHz to tolerate temperature and process variations.

The necessary VCO (default) tuning range is dictated by the LO frequency range, the LO chain architecture and specifically by the first rank of dividers used in the circuit.

Furthermore, in some applications, it could be of interest to change, in a continuous way, the IF frequency once the phase locked loop (PLL) of the VCO is locked. That could be done by widening, once again, the VCO frequency range.

However, widening the tuning range of a VCO generally means deteriorating the phase noise behaviour of the VCO. Furthermore, the wider the VCO band is, the greater the risk of synthesising a frequency within a forbidden band, and furthermore with poor phase noise figures.

It is therefore difficult to find a system that allows the tightest VCO frequency band as possible whilst tolerating frequency and process variations and also allowing tuning.

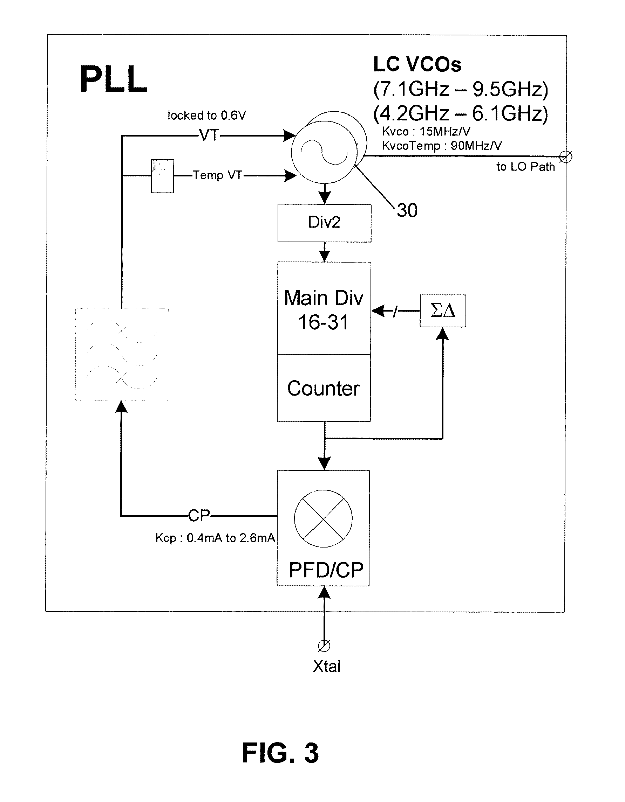

One known approach to compensate the temperature impact of the VCO is shown in Figure 3, and which provides a modified VCO design.

The frequency synthesis is realised by a phase locked loop ("PLL") with a tank of LC VCOs 30. The PLL has a phase frequency detector PFD and charge pump CP. A static control signal VT drives the VCOs and a feedback control loop controls a divider ratio to maintain the desired output frequency.

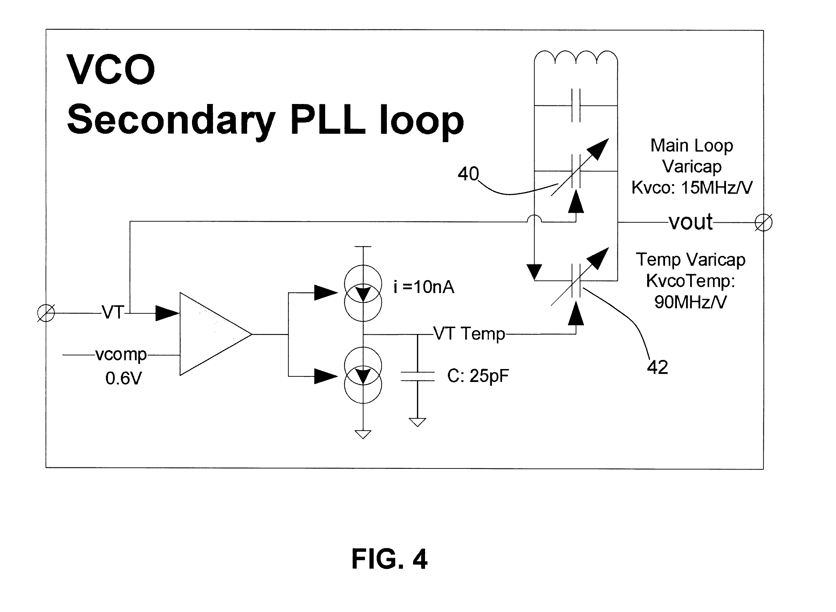

In order to compensate the temperature impact on the VCO and reduce the frequency tuning range per frequency band as much as possible, a secondary PLL loop is used as shown in Figure 4. The secondary loop has a switched capacitor bank and a bank of varactors. The inductor, shown in Figure 4 is shared between the two loops.

A calibration is done to set properly the switched capacitor bank as a function of the desired VCO frequency. This is done by fixing the voltage control value VT that controls the first varactor bank 40. VT will remain fixed during all the operating time of the PLL.

The secondary loop controls the second varactor bank 42, and compensates for the temperature variation using a voltage representing the temperature, "VT Temp".

As the temperature changes during operation, the VCO component values change. In a locked system, the VCO frequency remains stable and the control voltage VT moves. In this system, VT is kept fixed as a static command input (as sown in Figure 3), then the secondary loop compensates for the temperature variations.

Figure 4 shows how the loop operates. The setting VT is compared to a voltage reference vcomp that is equal to desired value of VT. Any differences between vcomp and VT are converted to a voltage "VT Temp" that controls the varactor value in order to cancel the VT variations and the temperature impact on the VCO.

Each time the desired frequency changes, the PLL has to be reset requiring a new calibration. VT is fixed to the same value at each new calibration. The difference in configuration between two different frequency settings is the programmation of the switched capacitor bank. Thus, once the PLL is calibrated (its output frequency programmed), the secondary loop reacts to keep the output frequency constant despite temperature changes. As the temperature changes, the signal "VT temp" changes to keep constant the output frequency.

One of the drawbacks of such a system is its design complexity and that, once the VCO frequency has been chosen, that frequency cannot be modified in a continuous way (for example in order to shift the LO signal frequency once the PLL has been programmed). The switched capacitors are fixed after the calibration and the VCO gain in the main PLL loop and the secondary loop are small (such as 15MH/V and 90MHz/V respectively - meaning that with a supply around 1V, the VCO frequency is able to shift by 105MHz).

According to an aspect of the invention, there is provided a system and method as claimed in the independent claims.

There is proposed a system for generating an output signal of a desired frequency, comprising:

a bank of at least two controllable oscillators, each having a frequency tuning range which varies with temperature, wherein each controllable oscillator has respective a temperature-tolerant tuning range which can be achieved at all temperatures within a desired temperature range of operation, wherein the temperature-tolerant tuning ranges of the controllable oscillators overlap in frequency such that they define in combination a combined temperature-tolerant tuning range which has a larger frequency tuning range than each individual controllable oscillator;
a testing arrangement for deriving the frequency tuning range of each controllable oscillator at a testing temperature;
a temperature sensor for sensing the testing temperature;
a processor for deriving the combined temperature-tolerant tuning range from the frequency tuning ranges and the sensed temperature, and for selecting which controllable oscillator to use to generate the output signal.

By "combined temperature tolerant tuning range" is meant the set of frequencies which can be achieved from at least one of the VCOs (i.e. a combined range) and at all possible temperatures (i.e. temperature-tolerant).

Preferably, the controllable oscillators are voltage controlled oscillators (VCOs).

This system uses multiple VCO of overlapping frequency tuning range, and in particular with tuning ranges which overlap for all temperatures. In this way the individual VCOs can be designed without extending the tuning range to tolerate temperature variations.

The invention provides a VCO design in which the temperature and process impact on its oscillation frequency does not need to be taken into account when specifying the required frequency tuning range of the individual VCOs. The multiple VCOs are then managed together in order to extend the global available frequencies. That management can be implemented in hardware or software. The system management then takes account of the process and temperature impacts on the VCO behaviour, rather than this being taken into account by the individual VCO design. Thus, the constraints of process and temperature previously tolerated by the VCO design are tolerated by VCO management. The VCO design specifications can thus be relaxed and this enables the phase noise and current consumption to be optimised.

A divider can be used for converting from a controllable oscillator frequency to a desired frequency. This desired frequency can for example be a local oscillator frequency, for example for use in downmixing an RF signal.

The testing arrangement can comprise a counter for counting cycles of the controllable oscillator and for controlling the oscillator to a maximum or minimum tuning range. By counting cycles over a fixed count duration, the frequency can be obtained.

The testing arrangement preferably comprises a divider for dividing the controllable oscillator output before counting.

The bank of oscillators can share a tuning control input (which can be provided with a voltage input or a digital input signal). In the case of an analogue signal, an analogue to digital converter can be used for digitising the tuning voltage input signal.

The invention also provides a method of generating an output signal of a desired frequency, using a system which comprises a bank of at least two controllable oscillators, each having a frequency tuning range which varies with temperature, wherein each controllable oscillator has respective a temperature-tolerant tuning range which can be achieved at all temperatures within a desired temperature range of operation, wherein the temperature-tolerant tuning ranges of the controllable oscillators overlap in frequency such that they define in combination a combined temperature-tolerant tuning range which has a larger frequency tuning range than each individual controllable oscillator, wherein the method comprises:

deriving the frequency tuning range of each controllable oscillator at a testing temperature;
sensing the testing temperature;
deriving the combined temperature-tolerant tuning range from the frequency tuning ranges and the sensed temperature; and
selecting which controllable oscillator to use to generate the output signal.

Examples of the invention will now be described in detail with reference to the accompanying drawings, in which:

Figure 1 shows the known use of a VCO to provide a local oscillator signal to control a mixer;
Figure 2 shows the use of multiple fixed dividers and a variable divider to provide tuning;
Figure 3 shows a PLL system that can compensate temperature variations;
Figure 4 shows the temperature compensation loop used in the system of Figure 3;
Figure 5 shows how temperature and process variations affect the VCO frequency bands;
Figure 6 shows in schematic form an example of circuit of the invention;
Figure 7 is used to show the control of the circuit of Figure 6;
Figure 8 shows the effect of temperature on VCO frequency bands;;
Figure 9 shows how thresholds can be set;
Figure 10 shows an example of circuit of the invention in more detail;
Figure 11 is used to explain the method of operation of the circuit of Figure 10;
Figure 12 is a graph to show that in some situations, there could be not enough margin to face temperature variations or VCO frequency shift after a PLL programmation;
Figure 13 is a graph to explain how the problem explained with reference to Figure 12 can be addressed; and
Figure 14 shows the PLL block diagram.

The invention provides a system for generating an output signal of a desired frequency in which a bank of at least two controllable oscillators are used, each having a temperature-tolerant tuning range which can be achieved at all temperatures within a desired temperature range of operation. These ranges of the oscillators overlap in frequency such that they define in combination a combined temperature-tolerant tuning range which has a larger frequency tuning range than each individual oscillator. The most suitable oscillator to use to generate the output signal is selected. This avoids the need for the individual oscillators to have a tuning range which is tolerant to temperature (and process) variations.

In one example, the invention is used to generate a local oscillator signal, which is a divided version of the original oscillator signal. Taking an example, the local oscillator tuning range may need to be at least equal to 50% starting at 5.86GHz. Due to process limitations (such as a maximum tuning ratio for a VCO using varactors of 33%), that range can be covered with three VCOs as defined in the table below. "VCO low" covers the range 5.86GHz .. 6.73GHz, "VCO mid" covers the range 6.73GHz .. 7.74GHz and "VCO high" covers the range 7.74GHz .. 8.83GHz.

For each frequency range, a margin needs to be added to cope with temperature and process variations, and a margin for additional options.

This "additional option" can for example relate to the capability to shift the IF frequency once the PLL is programmed (and after the VCO is selected). The capability of shifting IF freq by +/-2MHz (for example), impacts a $f_{LO}$ shift by +/-2MHz and impacts a fvco shift by +/-2MHz*$N_{LO}$. Thus, the additional VCO tuning range should be increased by +/-2MHz*$N_{LO}$.

These margins lead to extended frequency ranges far above the maximum tolerated by the process as shown in the table below:

| VCO Bands (GHz) | VCO Low | | VCO mid | | VCO high | |
|---|---|---|---|---|---|---|
| | fmin | fmax | fmin | fmax | fmin | fmax |
| | 5,86 | 6,73 | 6,73 | 7,74 | 7,74 | 8,83 |
| Min TR due to LO architecture | 15% | | 15% | | 14% | |
| TR widenned due to temperature & process robustness (+/-7%) | 5,47 | 7,2 | 6,29 | 8,29 | 7,24 | 9,45 |
| TR widenned due other applications (+/- 0,4GHz for each bands) | 5,07 | 7,6 | 5,89 | 8,69 | 6,84 | 9,85 |
| TR for robust design and spec fullfilment | 50% | | 48% | | 44% | |

The value of +/- 0.4GHz is used to represent the product +/-2MHz*$N_{LO}$.

As shown, a 7% tolerance resulting from temperature and process variations and a 0.4GHz additional band means that the VCOs need up to 50% tuning range.

The frequency range distribution to three VCOs thus leads to a technical stalemate.

In accordance with the invention, the local oscillator signal generation is made insensitive to the temperature and process variations. By removing the need for the VCO to tolerate temperature and process variations, the following results are obtained:

| VCO Bands (GHz) | VCO Low | | VCO mid | | VCO high | |
|---|---|---|---|---|---|---|
| | fmin | fmax | fmin | fmax | fmin | fmax |
| | 5,86 | 6,73 | 6,73 | 7,74 | 7,74 | 8,83 |
| Min TR due to LO architecture | 15% | | 15% | | 14% | |
| TR widenned due other applications (+/- 0,4GHz for each bands) | 5,46 | 7,13 | 6,33 | 8,14 | 7,34 | 9,23 |
| TR for robust design and spec fullfilment | 31% | | 29% | | 26% | |

The invention enables this by using multiple oscillators (such as VCOs) which are combined to extend the range of the synthesisable frequencies.

The frequencies that the VCOs can synthesise (dependent on the process which has been used) is then determined at a given temperature. The available frequencies can then be extrapolated to take account of possible temperature deviations.

Based on the desired local oscillator frequency to synthesise, the best VCO and the best LO chain divider can be selected to provide the desired LO frequencies. Thus, the invention can combine a bank of dividers as well as a bank of VCOs.

The arrangement of the invention removes the process and temperature constraints on the frequency range as part of the VCO design. Instead, these constraints are overcome by VCO management, which can be implemented either by hardware or software.

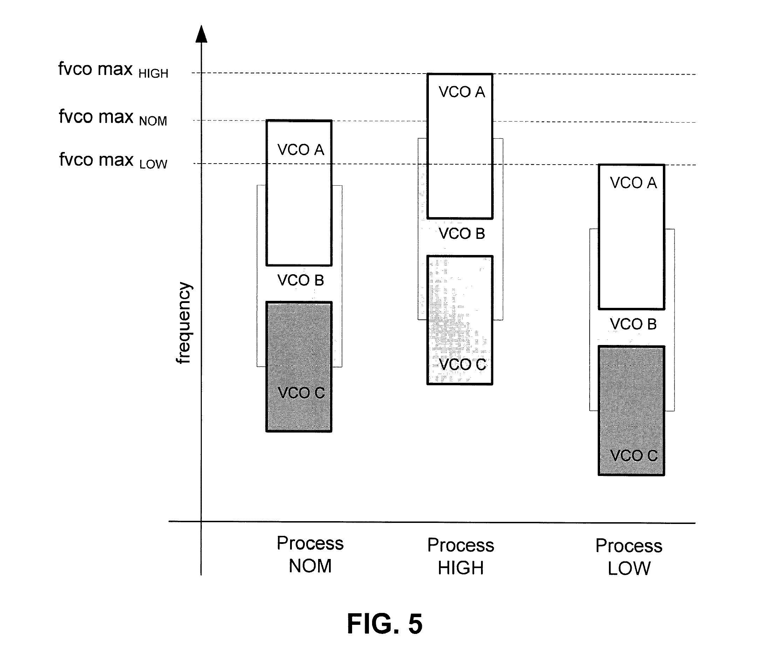

The process impacts the VCO frequency bands as shown in Figure 5, which represents three different process conditions, named NOM, HIGH and LOW by way of example. The figure shows the VCO tuning range for three different VCOs (named VCO A, VCO B and VCO C) at a single temperature, and with the three VCOs formed by the different process conditions. The VCOs differ in the components used to form them, for example the inductor and capacitor used, but the different VCOs are formed by the same process.

For a given temperature, different values of maximum $f_{VCO}$ characterise different process conditions.

As described above, the division ratio $N_{LO}$ to be used depends on the maximum VCO frequency. As that value changes with the process, the required value of $N_{LO}$ also differs.

In order to set the value of $N_{LO}$ properly, it is required to know the VCO maximum frequency. As the potential process impacts on VCO frequencies are known, the set of values $\left(N_{LO_i}\right)_{i \in [1..n]}$ can be chosen to cover these process variations. In this way, whatever process variations are possible and their impact on the VCO frequencies, there will be always a value of $N_{LOi}$ that will give the desired divided frequency $f_{LO}$.

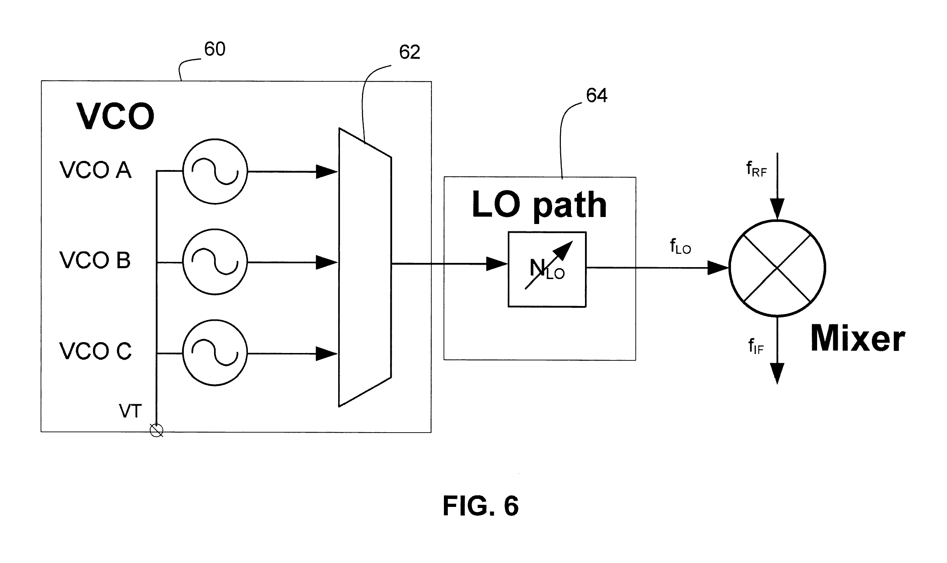

Figure 6 shows an example of the system of the invention.

There is a bank 60 of VCOs. In this example, there are three VCOs, VCO A, VCO B and VCO C. The bank is controlled by a single voltage tuning control input VT, which in this example is an analogue voltage, but it may instead by a digital signal in the case of a digitally controlled oscillator (DCO). One VCO is selected, by a multiplexer 62, and its output is supplied to the local oscillator path 64 were variable division takes place.

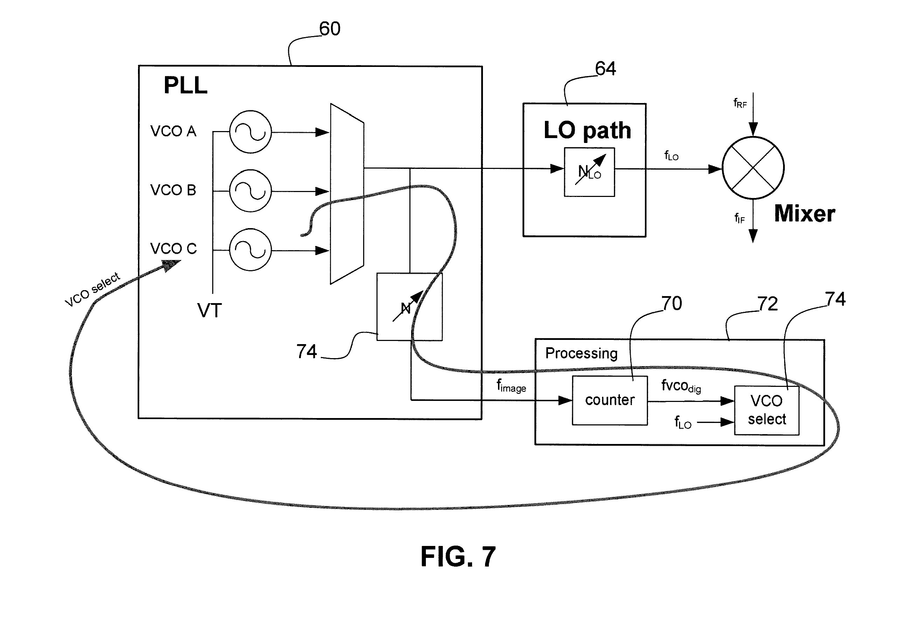

In order to determine which VCO output is needed, and the division ratio, the first step is to count the maximum and minimum frequency that each VCO can synthesise. As shown in Figure 7, this is done using a counter 70 within a processing module 72.

The counter is used to perform a count over a fixed count duration. The duration is greater than one VCO period. In the example, the frequency to be counted is $fvco/N_{PLL}$. The more the frequency measurement shall be accurate, the longer the counting time window. To get a measurement precision better than 1%, the counting time window can be greater that hundreds of periods of duration $N_{PLL}/fvco$. The count time window is a multiple of the digital clock period.

The temperature at which the sensing is carried out is sensed using an embedded temperature sensor. From the measured VCO performance, a suitable VCO is selected for a given desired local oscillator frequency $f_{LO}$ by the selector 74. This is explained below.

The temperature information and measured available frequencies are provided to a management unit that derives the available frequencies at the maximum and the minimum specified temperatures. Based on those measurements, the processing unit can extrapolate the VCO available frequencies whatever the system temperature could be. With the VCO available frequencies overlapping, they together define a continuous range, which is temperature tolerant, in the sense that all frequencies can be generated regardless of the system temperature (within the defined range).

Depending on the desired local oscillator frequencies, the required VCO and local oscillator chain divider settings are chosen to enable the desired frequency synthesis for any temperature within the permitted range

With reference to Figure 7, an image of the VCO frequency after suitable division ($f_{image}$ = fvco/N) is sent to the counter 70 that measures the $f_{image}$. For this purpose, a divider 74 is provided as part of the VCO array.

Note that the divider in the LO path could equally be used for dividing the VCO signal before counting, in which case the output of the LO path can be provided to the processor 72.

As the value of the divider ratio N is known, post processing returns the value of fvco.

The tuning voltage VT is set to its high level to obtain the maximum frequency, or to its low level to obtain the minimum frequency. In this way, the minimum and maximum VCO frequencies can be measured for each VCO. This measure is performed in combination with temperature sensing.

With knowledge of the frequency temperature coefficients of each VCO, the VCO bands can be extrapolated at specified minimum and maximum temperatures.

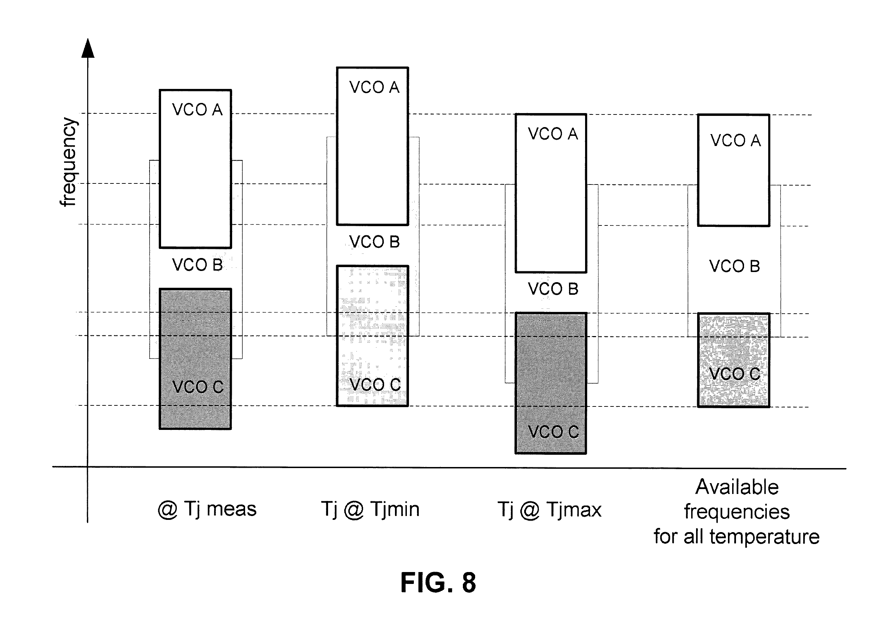

Figure 8 shows how the different VCO bands can move as a function of the temperature. It shows the measured minimum and maximum values of each VCO and the calculated versions at the maximum and minimum junction temperatures, Tjmax and Tjmin respectively.

The available frequencies which can be achieved for all temperatures can then be derived as shown as the right plot in Figure 8.

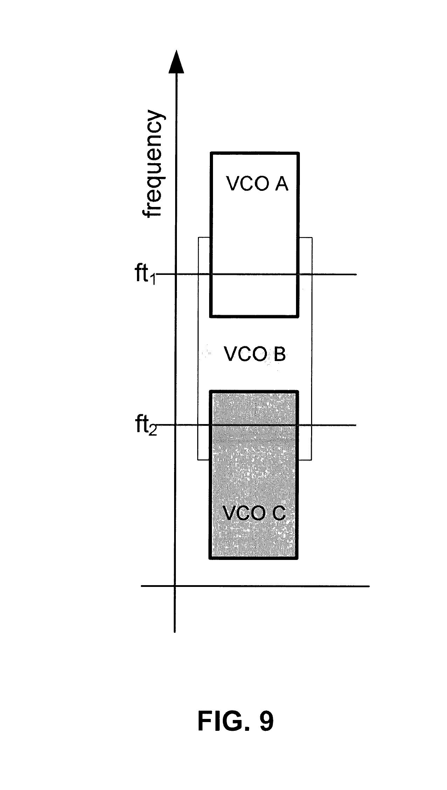

Figure 9 shows this plot in more detail. It shows the VCO frequencies for each VCO which can be achieved regardless of junction temperature.

The tuning range of each VCO varies with temperature. Figure 9 can be considered to show a temperature-tolerant tuning range for each VCO, in that each VCO can produce the frequencies shown with the respective rectangle at all temperatures within the desired temperature range of operation. These temperature-tolerant tuning ranges of the different voltage controlled oscillators overlap in frequency, such that they define in combination a combined and continuous temperature-tolerant tuning range which has a larger frequency tuning range than each individual voltage controlled oscillator.

Any given VCO frequency (fvco) may be synthesisable by one or by two VCOs if the frequency is in a region of overlap between the possible outputs of two VCOs. In the case of two VCOs, a choice has to be made.

For this purpose, threshold frequencies are defined which fall within the common (overlapping) temperature-tolerant frequency band of the two VCOs. In the case of three VCOs, two threshold frequencies $ft_1$ and $ft_2$ are defined as shown in Figure 9.

When the desired fvco is greater than ft1, VCO A is chosen. If fvco is smaller than $ft_2$, then VCO C is selected. When the fvco value is between $ft_1$ and $ft_2$, then VCO B is chosen.

Thus, the chosen VCO will be able to synthesise the desired frequency whatever the temperature evolution could be within the range of the specified maximum and minimum junction temperature.

For each VCO, the temperature dependency is known, and it can be closely approximated as a linear dependency of the output frequency on temperature.

The temperature dependency is known by the manufacturer having been implemented in component models by the manufacturer. The VCO frequency shift by +/-3% (mentioned above) is a consequence of the component model within the range of the specified temperatures..

For example, the temperature coefficient of the VCO frequencies can simply be defined as $a_A$, $a_B$ and $a_C$ for the VCO A, VCO A and VCO C, respectively. This assumes a linear dependency on temperature.

Once the maximum and minimum frequency for each VCO is obtained at the measurement temperature Tjmeas, the VCO bands can be derived at the minimum and maximum temperature (for instance, for VCO A: $fvcoMin(Tj_{meas})$ and $fvcoMax(Tj_{meas})$)

$$\begin{cases} fvcoA_{max}(Tj_{max}) = fvcoA_{max}(Tj_{meas}) + a_A(Tj_{max} - Tj_{meas}) \\ fvcoA_{min}(Tj_{max}) = fvcoA_{min}(Tj_{meas}) + a_A Tj_{meas} \end{cases}$$

This is a simply linear extrapolation which enables the VCO bands to be obtained at $Tj_{min}$ and $Tj_{max}$ as well as the range valid for any temperature (Figure 9).

ft1 and ft2 can then be obtained. For example, they could be equal to:

$$ft_1 = \frac{1}{2}[fvcohigh_{min}(Tj_{max}) + fvcomid_{max}(Tj_{min})]$$

$$ft_2 = \frac{1}{2}[fvcomid_{min}(Tj_{max}) + fvcolow_{max}(Tj_{min})]$$

This places the thresholds half way up the region of overlap.

The VCO temperature coefficients are typically empirical (i.e. observed) values and may contain small errors.

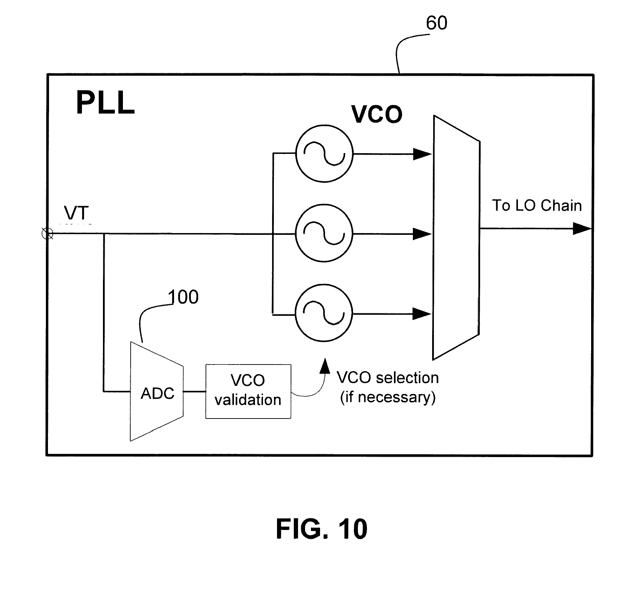

An additional ADC can be used that gives a digital value of VT if is it an analog signal. This ADC 100 is shown in Figure 10. Due to inaccuracies in the temperature coefficients, the position of the VCO frequency band estimation at Tjmax and Tjmin may be slightly corrupted. That would induce corrupted threshold frequencies and then, the VCO selection could be not the optimum one. If that is the case, then the value of VT will be too low or too high and then. the PLL may unlock if temperature changes or if the management system asks to shift the output frequency with the same VCO.

This is resolved by providing VT with enough margin regarding its maximum or minimum value. That margin is used when the temperature changes or when a change in the output frequency is desired, for example if a television desires a shift in the IF frequency. The system is designed to have enough VT margin one the PLL is programmed. However, this margin may be too small in the event of errors in the temperature coefficients used to calculate the frequency bands.

The system can monitor these margins thanks to the ADC sensing VT. After having selected the VCO for the desired frequency, the output of the ADC is read, and the system verifies whether enough frequency margin remains after a PLL locking. In particular, the ADC monitors the value of VT and the processor unit determines after receiving VT from the ADC if the margin is too small (if VT is too high or too small). In this case, the process unit takes the decision to select the upper VCO or the lower VCO (the one that synthesises higher frequencies or the one that synthesises lower frequencies).

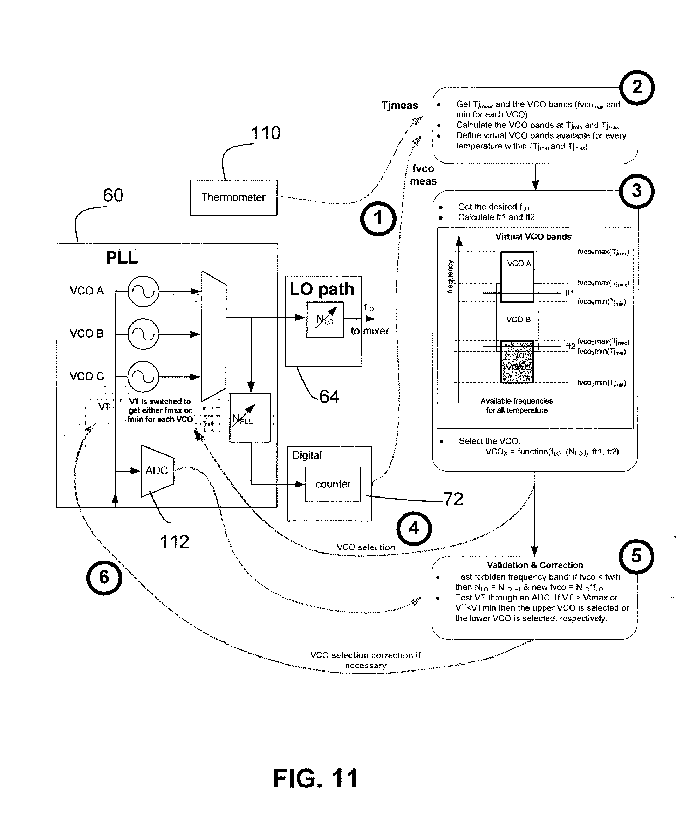

The overall system operation is explained with reference to Figure 11, which shows the VCO bank 60, the local oscillator path 64, the processing unit 72 as well as the integrated temperature sensor 110.

The first step of the use of the circuit is to obtain the measured temperature Tjmeas and the VCO frequency bands (fmax and fmin for each VCO). This is shown as step 1.

The frequency bands for Tjmin and Tjmax are calculated and then the overall frequency band information (of Figure 9) is derived. This is shown as step 2.

The thresholds shown in Figure 9 are defined as shown in step 3. The desired output frequency $f_{LO}$ is received as input.

Based on this information, a VCO can be selected. This selection is based on the desired output frequency, the thresholds defined at the VCO frequencies, and the available divider ratios in the local oscillator path. Thus, a VCO is selected as well as the required divider ratio to translated from the VCO frequency to the LO frequency.

In step 5, testing is carried out.

**Test 1. $f_{VCO} < f_{WIFI;}$ ($f_{WIFI}$=5.845MHz)**

The first test is to avoid interference from the WIFI band.

The WIFI upper frequency band ends at 5.845GHz. Thus, if the VCO frequency is smaller than 5.845GHz, that frequency may belong to the WIFI band. If the VCO frequency belongs to the WIFI band, a WIFI interferer may have the same frequency as the selected VCO.

There will then be an electromagnetic coupling between the interferer and the VCO. The oscillation of the VCO will be disturbed, inducing parasitic oscillations and a significant decrease of the VCO phase noise figures.

A test is thus carried out to determine if $f_{VCO}$ is below $f_{WIFI}$. By choosing a greater value of $N_{LO}$, a new of $f_{VCO}$ will be obtained which will be greater than $f_{WIFI}$ (since fvco = $N_{LO}*f_{LO}$).

More generally, this approach can be used to avoid interference from any frequency band where it is known that signals may be present.

**Test 2: Using the ADC**

An analogue to digital converter 112 is used to convert the tuning voltage VT to a digital value (if an analogue controlled VCO is used). The value of VT controls the VCO frequency. In the example above, it controls the capacitor value of a varactor, inducing a control of the oscillation frequency of the VCO. Once the PLL is programmed, if VT is too close to its maximum or minimum value, the capacitance value modification will be limited and then the VCO frequency modification will be limited. That modification capability could not be enough to compensate temperature variation after the PLL programmation or/and to react as the TV user shifts the IF frequency.

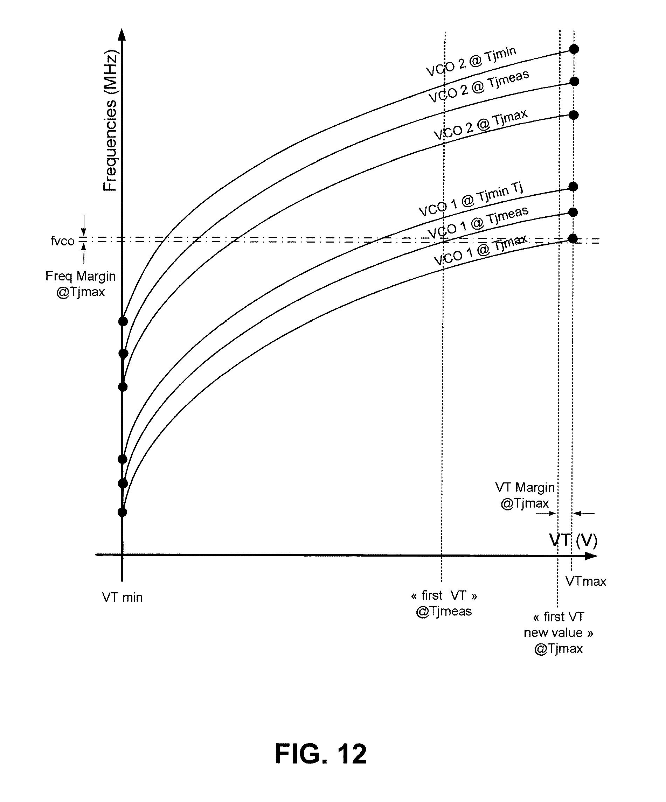

Taking an example, Figure 12 shows the frequency bands of two VCOs at three temperatures, Tjmeas, Tjmax and Tjmin.

After the first PLL and VCO programmation at the temperature Tjmeas, VCO 1 is selected (the lower set of curves) and once the PLL is locked, VT = "first VT". After a while, the junction temperature Tj has increased (for example the room temperature is higher, or the TV is in the sun...) and Tj reaches Tjmax. As the PLL is a locked system, the VCO frequency will remain the same and the PLL loop compensates the temperature change by adjusting the VT value to keep the VCO oscillation at the same frequency.

Thus, VT reaches a new value which is shown as "first VT new value" at Tjmax.

There can then be a problem if the TV user wants to shift the IF frequency to a higher value. Figure 12 shows the positive frequency margin available at Tjmax. The margin is too small to face any significant frequency shift required by the TV user.

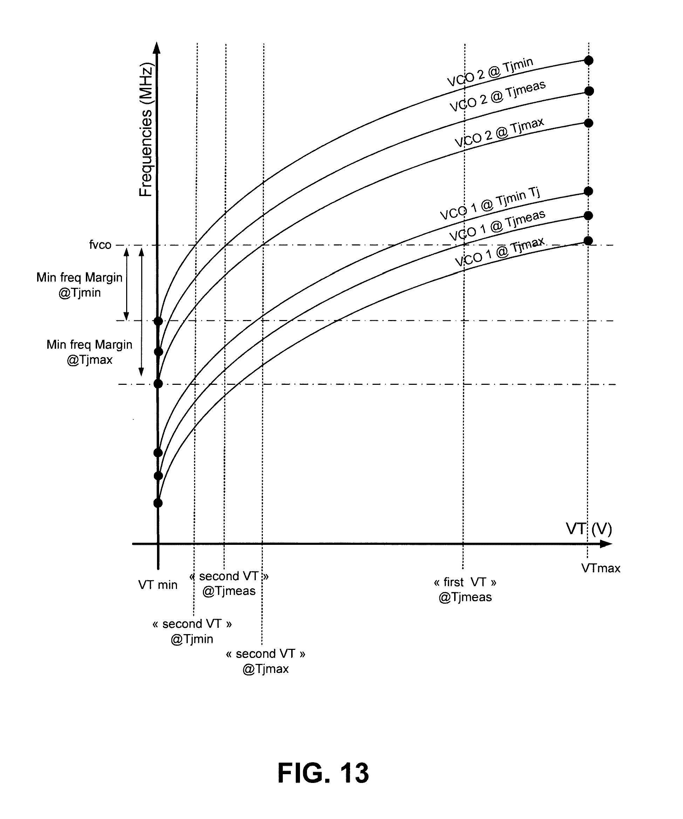

The solution is to select the "upper" VCO, namely VCO 2 as shown in Figure 13. The VT (called "second VT") margin and frequency margin will be bigger than with the VCO 1.

In this way, a higher frequency or lower frequency VCO can be selected if the remaining margin in VT is not deemed sufficient. In this way, an adjustment margin in the control signal VT for controlling the selected VCO is determined and if the margin in VT is too small, a different VCO is selected.

After reselecting a new VCO, the ADC test should then to be carried out again to test if VT margin has been improved thanks to the new VCO selection.

If the margin in VT becomes insufficient when the VCO with the highest or lowest frequency band is already selected, the divider ration $N_{LO}$ can be changed (reduced if the highest frequency VCO was selected or increased if the lowest frequency VCO was selected)

In these two tests, the divider ratio $N_{LO}$ can change during Test 1 since a reprogramming is required, but it is not needed during Test 2.

The invention can be applied in any frequency synthesisers and more especially in any wide band frequency synthesisers. For example, the invention can be used as part of an RF receiver in a cable television system.

As will be clear from the description above, the invention can be used to generate a local oscillator signal for frequency downmixing. In this application, the invention enables the IF signal frequency to be shifted significantly after the PLL is locked without changing the local oscillator chain divider state. Taking the example of a TV tuner, once the user is watching the TV the LO path should remain static otherwise, the picture is deteriorated, and the preferred way to make tuning adjustments is thus by changing slowly the value of VT.

To change the value of VT, the internal PLL divider is used.

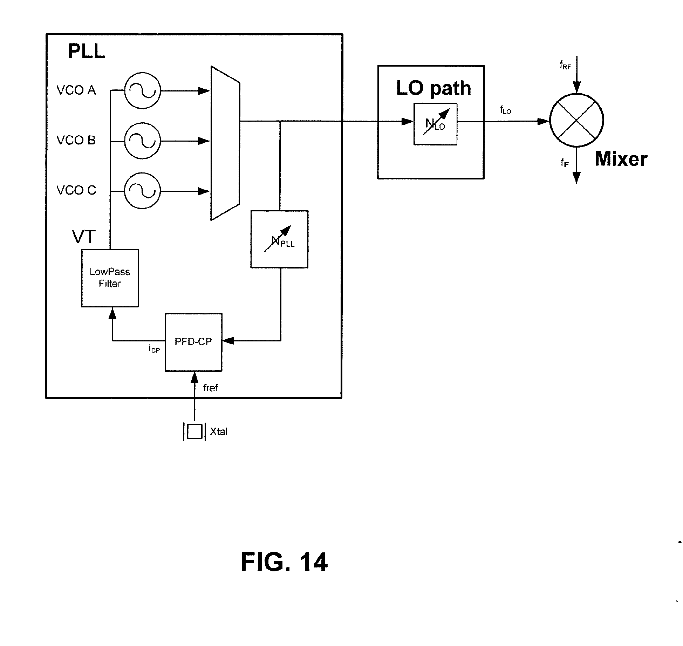

Figure 14 shows the control loop for adjusting VT. The value of $N_{PLL}$ is changed, with a consequent change in VCO frequency given by $f_{VCO}=N_{PLL}*f_{ref}$; This reference frequency fref is the phase frequency detector comparison frequency (as used in the PLL) and this can come from a crystal oscillator (Xtal) as shown. By changing $N_{PLL}$, VT change also to tune the VCO frequency to its new value (respecting $N_{PLL}*f_{ref}$).

This avoids reprogramming the PLL or the local oscillator chain during signal reception, which can prevent the IF signal integrity being preserved.

The example above has three VCOs. Of course, the invention can be applied to a system with two VCOs, or indeed a system with more than three VCOs, such as four or five.

It will be clear to one of ordinary skill in the art that some or all of the processing steps described can be embodied in a logic apparatus, or a plurality of logic apparatus, comprising logic elements arranged to perform the steps of the method and that such logic elements may comprise hardware components, firmware components or a combination thereof, or indeed as software running on one or more processors

Other variations to the disclosed embodiments can be understood and effected by those skilled in the art in practising the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage. Any reference signs in the claims should not be construed as limiting the scope.

**Claims**

1. A system for generating an output signal of a desired frequency, comprising:

   a bank (60) of at least two controllable oscillators, each having a frequency tuning range which varies with temperature, wherein each controllable oscillator has respective a temperature-tolerant tuning range which can be achieved at all temperatures within a desired temperature range of operation, wherein the temperature-tolerant tuning ranges of the controllable oscillators overlap in frequency such that they define in combination a combined temperature-tolerant tuning range which has a larger frequency tuning range than each individual controllable oscillator;
   a testing arrangement (72) for deriving the frequency tuning range of each controllable oscillator at a testing temperature;
   a temperature sensor (110) for sensing the testing temperature;
   a processor (72) for deriving the combined temperature-tolerant tuning range from the frequency tuning ranges and the sensed temperature, and for selecting which controllable oscillator to use to generate the output signal.

2. A system as claimed in claim 1, wherein the controllable oscillators comprises voltage controlled oscillators.

3. A system as claimed in claim 1 or 2, further comprising a divider (64) for converting from a controllable oscillator frequency to a desired local oscillator frequency.

4. A system as claimed in any preceding claim, wherein the testing arrangement (72) comprises a counter (70) for counting cycles of the controllable oscillator and for controlling the controllable oscillator to a maximum or minimum tuning range.

5. A system as claimed in claim 4, wherein the testing arrangement (72) comprises a divider (74) for dividing the controllable oscillator output before counting.

6. A system as claimed in any preceding claim, wherein the bank (60) of controllable oscillators share a tuning control input (VT).

7. A system as claimed in claim 6, further comprising an analogue to digital converter (112) for digitising a tuning voltage input signal.

8. An RF receiver comprising a system as claimed in any preceding claim for generating a local oscillator signal.

9. A method of generating an output signal of a desired frequency, using a system which comprises a bank (60) of at least two controllable oscillators, each having a frequency tuning range which varies with temperature, wherein each controllable oscillator has respective a temperature-tolerant tuning range which can be achieved at all temperatures within a desired temperature range of operation, wherein the temperature-tolerant tuning ranges of the controllable oscillators overlap in frequency such that they define in combination a combined temperature-tolerant tuning range which has a larger frequency tuning range than each individual controllable oscillator, wherein the method comprises:

deriving the frequency tuning range of each controllable oscillator at a testing temperature;
sensing the testing temperature;
deriving the combined temperature-tolerant tuning range from the frequency tuning ranges and the sensed temperature; and
selecting which controllable oscillator to use to generate the output signal.

10. A method as claimed in claim 9, comprising converting from a controllable oscillator frequency to the desired frequency.

11. A method as claimed in claim 9 or 10, wherein the testing comprises counting cycles of the controllable oscillator and controlling the controllable oscillator to a maximum tuning range and to a minimum tuning range.

12. A method as claimed in claim 11, wherein the testing comprises dividing the controllable oscillator output before counting.

13. A method as claimed in any one of claims 9 to 12, wherein the bank of controllable oscillators share a tuning voltage input (VT) and the method comprises digitising the tuning voltage input signal.

14. A method as claimed in any one of claims 9 to 13, comprising determining if the controllable oscillator frequency falls within a frequency band to be avoided, and adjusting the required controllable oscillator frequency if necessary.

15. A method as claimed in any one of claims 9 to 14, comprising determining an adjustment margin in the control signal for controlling the selected controllable oscillator and if the margin is too small, selecting a different controllable oscillator.

**FIG. 1**

FIG. 2

**FIG. 3**

# VCO
# Secondary PLL loop

Main Loop Varicap Kvco: 15MHz/V

40

vout

i = 10nA

Temp Varicap KvcoTemp: 90MHz/V

VT

vcomp
0.6V

VT Temp

C: 25pF

42

**FIG. 4**

EP 2 775 626 A1

FIG. 5

**FIG. 6**

**FIG. 7**

EP 2 775 626 A1

FIG. 8

FIG. 9

**FIG. 10**

**FIG. 11**

FIG. 12

**FIG. 13**

**FIG. 14**

Europäisches
Patentamt

European
Patent Office

Office européen
des brevets

# EUROPEAN SEARCH REPORT

Application Number

EP 13 29 0045

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2011/298503 A1 (OBKIRCHER THOMAS [US] ET AL) 8 December 2011 (2011-12-08) * paragraph [0022] - paragraph [0060]; figures 1-6 * ----- | 1-15 | INV. H03L7/099 H03L1/02 H03L7/183 |
| X | US 8 358 159 B1 (EKER MEHMET MUSTAFA [US] ET AL) 22 January 2013 (2013-01-22) * column 2, line 19 - column 6, line 42; figures 1-3,4A,4B * ----- | 1-15 | |
| A | US 2003/060177 A1 (NOBORU MITSUHIRO [JP] ET AL) 27 March 2003 (2003-03-27) * paragraph [0084] - paragraph [0138]; figures 1-16 * ----- | 1-15 | |

TECHNICAL FIELDS SEARCHED (IPC)

H03L

The present search report has been drawn up for all claims

| Place of search | Date of completion of the search | Examiner |
|---|---|---|
| The Hague | 24 July 2013 | Aouichi, Mohamed |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 13 29 0045

This annex lists the patent family members relating to the patent documents cited in the above-mentioned European search report.
The members are as contained in the European Patent Office EDP file on
The European Patent Office is in no way liable for these particulars which are merely given for the purpose of information.

24-07-2013

| Patent document cited in search report | Publication date | Patent family member(s) | Publication date |
|---|---|---|---|
| US 2011298503 A1 | 08-12-2011 | US 2011298503 A1<br>WO 2011152881 A2 | 08-12-2011<br>08-12-2011 |
| US 8358159 B1 | 22-01-2013 | NONE | |
| US 2003060177 A1 | 27-03-2003 | FR 2830142 A1<br>JP 3795364 B2<br>JP 2003110425 A<br>US 2003060177 A1 | 28-03-2003<br>12-07-2006<br>11-04-2003<br>27-03-2003 |

EPO FORM P0459

For more details about this annex : see Official Journal of the European Patent Office, No. 12/82